# EUROPEAN PATENT APPLICATION

(11) **EP 4 258 298 A1**
(43) Date of publication of application: **11.10.2023**
(21) Application number: 22305437.0
(22) Date of filing: 04.04.2022
(51) Int. Cl.: H01F 6/06, H01F 41/04, H01L 39/00

(54) **METHOD FOR MANUFACTURING SUPERCONDUCTING COILS AND DEVICE**

(71) Applicant: Renaissance Fusion, 38600 Fontaine (FR)
(72) Inventor: KOCHAT, Mehdi, 38600 Fontaine (FR); VOLPE, Francesco, 38600 Fontaine (FR)
(74) Representative: Cabinet Beaumont

(57) **Abstract**

The present disclosure relates to a method for manufacturing a superconducting coil, the method comprising steps of:
- providing a structure (202);
- rotating the structure;
- forming a first stacking of layers on the rotating structure in a cold chamber (103); and
- forming a second stacking of layers on the first stacking of the rotating structure in a hot chamber (105) at a temperature higher than the temperature in the cold chamber.

## Description

### Technical field

The present disclosure is related to methods or processes and devices for manufacturing superconducting coils. More specifically it is related to methods or devices that involve a multistage coating of a surface of a structure. The structure may be for example a cylinder in its broader definition, that is, a surface in space made of parallel straight lines (generating lines), and the surface may be an inner or an outer surface of the cylinder.

### Background art

The challenges of the 21st century must be met with technology that pushes the current boundaries of science. Energy generation from fusion power, medical procedures like magnetic resonance imaging machines and transportation system like magnetic levitation trains, among many others, all have in common that they require strong magnetic fields in specific configurations to function properly. Therefore, the world of the future will require methods, devices and mechanisms that can produce strong magnetic fields and that meet the demands of a growing sector.

The latest developments in magnetic fields make use of High-Temperature Superconductors (HTS). HTS are materials that exhibit superconducting properties at temperatures generally above 77 K, the boiling point of nitrogen. HTS materials exhibit a resistance of zero under the superconducting circumstances, which is usually a matter of being at the right temperature. Having zero resistance, currents can flow freely and at high intensity through these superconducting materials. Ultimately this makes it possible to produce magnetic fields of high strength and with specific characteristics as required by the application.

Presently, magnetic devices are constructed with large magnets that are shaped into the form of a coil; magnets may be either permanent or electrical depending on cost or application. In applications where the field needs a special configuration, for instance, in stellarators, the coil must be twisted to a complicated shape during construction. This greatly increases costs during the design phase; stellarator design is very complicated and requires a lot of testing, so constructing many magnets coils requires a lot of time and of money.

A document dealing with the construction of superconducting coils is U.S. Pat. No. 9,812,233 to Sazaki, et. al., which describes the current state of the art concerning the construction of superconducting material films, also described as tapes. The current state of the art considers producing tapes which are stacked to form a cable like structure. This cable like structure is then shaped according to the needs of the application. It may be cut to shape, twisted, stacked or otherwise.

A method for constructing superconducting coils is described in U.S. Pat. No. 8,655,423 to Miyazaki, et al. Miyazaki describes a superconducting coil formed of several layers of different materials. A group of these layers is described as constituting a superconducting coil portion which is formed of thin-film superconducting wires. The coils described by Miyazaki and those that are common in the art are constructed by arranging superconducting films, also called superconducting tapes, into the shape of wires and the wires are then further configured into the shape of coils. According to a review of the prior art, superconducting coils are formed by stacking superconducting films or layers so that electric current may flow in a desired direction and produce the appropriate magnetic field configuration.

To the best knowledge and understanding of the inventors, the prior art doesn't teach any other method by which the superconducting films or tapes may be used to conduct a current.

The tapes themselves can be constructed through several methods described in the art. In US Pat. No. 10, 935, 799 to Majkic, et al. a method for fabricating high quality superconducting tapes is disclosed. The method of Majkic is limited to applications that require a very thin tape structure. It is not apparent from the description of Majkic how the process may defeat the limitations of, for example, different tape geometries. The method described in this prior art is limited to the rectangular shape of the appropriate size.

An apparatus and method for forming a film on a tape substrate is disclosed in US. Pat. No. 6,147,033 to Youm et al. This apparatus further exemplifies the limitations of the current methods in the state of the art. A thin film of superconducting material is deposited on a rolling cylinder, that unwinds a tape substrate, thus forming the tape. This method does not allow for a different shape than that of a rectangular tape. Further, if the tape is left for an inordinate amount on tape on the rolling cylinder, the whole tape could be damaged.

Superconducting tapes themselves are also in short supply, as their demand is high. There is also the problem of the size and shape of the tapes which can only be constructed a few centimeters wide. In addition, the process that arranges the tapes into wires and further into coils is lengthy and error prone.

Thus, there remains a need for an efficient and less costly alternative to the coils that are used in magnetic applications. Further, there is a need for a method or device that allows for the construction of superconducting coils that can be easily interchanged, so that configuration changes may be realized quickly and at a little cost. The prior art is yet to overcome the limitation of producing superconducting tapes of any shape or size, currently shapes are limited to rectangular geometries.

### Summary of Invention

One embodiment addresses all or some of the drawbacks of known methods and devices for constructing superconducting coils.

One embodiment provides a method for manufacturing a superconducting coil, the method comprising steps of:
- providing a structure;
- rotating the structure;
- forming a first stacking of layers on the rotating structure in a cold chamber; and
- forming a second stacking of layers on the first stacking of the rotating structure in a hot chamber at a temperature higher than the temperature in the cold chamber.

In one embodiment, the method further comprises, after the rotating step and before forming the first stacking, a step of electropolishing the structure in a wet chamber, for example using an electrolytic solution and electrodes.

In one embodiment, the wet chamber, the cold chamber and the hot chamber are a single chamber.

In another embodiment, the wet chamber, the cold chamber and the hot chamber are separate chambers.

In one embodiment:
- the step of forming the first stacking in the cold chamber (103) comprises using at least an ejector adapted to a physical vapor deposition step, like a nozzle and/or a target; and/or
- the step of forming the second stacking in the hot chamber (105) comprises using at least an ejector adapted to a physical vapor deposition step and/or to a chemical vapor deposition step, like a nozzle and/or a target.

In one embodiment, the temperature in the cold chamber (103) is the room temperature.

In one embodiment, the temperature in the hot chamber is higher than 500°C.

In one embodiment, forming the first stacking comprises at least a physical vapor deposition step, like sputtering, for example magnetron sputtering, inclined substrate deposition, ion beam deposition and/or ion beam assisted deposition.

In one embodiment, forming the first stacking comprises:
- depositing, for example using sputtering or ion beam deposition, a first layer of a material like alumina on the structure;
- depositing, for example using sputtering or ion beam deposition, a second layer of a material like yttria on the first layer; and
- depositing, for example using sputtering or ion beam assisted deposition, a third layer of a material like magnesium oxide or yttrium stabilized zirconia on the second layer.

In one embodiment, forming the second stacking comprises at least a physical vapor deposition step, for example sputtering or pulsed laser deposition, and/or a chemical vapor deposition step, for example a metal organic chemical vapor deposition step.

In one embodiment, forming the second stacking comprises depositing at least a layer of a superconductive material, for example rare-earth barium copper oxide or yttrium barium copper oxide, using metal-organic chemical vapor deposition, for example using a vaporized precursor at a uniform temperature and laminar flow, or using pulsed laser deposition.

In one embodiment, forming the second stacking comprises a step of depositing a layer of a low-resistivity material like silver on the superconductive material layer.

In one embodiment, forming the second stacking comprises:
- heating the structure to a first temperature, for example between 700°C and 800°C;
- depositing, for example using metal-organic chemical vapor deposition or pulsed laser deposition, a fourth layer of a material like magnesium oxide or yttrium stabilized zirconia on the first stacking;
- depositing, for example using metal-organic chemical vapor deposition or pulsed laser deposition, a fifth layer of a material like lanthanum manganite on the fourth layer;
- depositing, for example using chemical vapor deposition, metal-organic chemical vapor deposition or pulsed laser deposition, a sixth layer of a superconductive material, for example rare-earth barium copper oxide or yttrium barium copper oxide, on the fifth layer;
- cooling the structure to a third temperature lower than the first temperature, for example between 450°C and 600°C; and
- depositing, preferably using chemical vapor deposition or metal-organic chemical vapor deposition, a seventh layer of a low-resistivity material like silver on the sixth layer.

In one embodiment, the cooling step comprises injecting an inert gas or vapor at a fourth temperature lower than the third temperature.

In one embodiment, the step of depositing the sixth layer comprises filling in the hot chamber a vaporized superconductive material precursor at a fifth temperature, for example between 250°C and 280°C.

In one embodiment, the method further comprises heating the structure to a second temperature higher than the first temperature, for example between 800°C and 900°C, between depositing the fifth layer and depositing the sixth layer.

In one embodiment, the method further comprises repeating the steps of forming the second stacking, in the same or in different order, in order to form at least multiple second stackings on the first stacking, preferably several times, for example between 4 and 80 times.

In one embodiment, the method further comprises, preferably after the step of forming the second stacking or the multiple second stackings:
- stopping the rotation of the structure; and/or
- cooling the structure to the room temperature.

One embodiment provides a superconducting coil obtained by the method according to an embodiment, the superconducting coil comprising:
- a structure;
- a first stacking of layers on the structure;
- a second stacking of layers on the first stacking.

In one embodiment:
- the first stacking of layers on the structure comprises:
   - a first layer of a material like alumina on the structure;
   - a second layer of a material like yttria on the first layer;
   - a third layer of a material like magnesium oxide on the second layer;
- at least a second stacking of layers on the first stacking comprising:
   - a fourth layer of a material like magnesium oxide or yttrium stabilized zirconia on the third layer;
   - a firth layer of a material like lanthanum manganite on the fourth layer;
   - a sixth layer of a superconductive material like rare-earth barium copper oxide or yttrium barium copper oxide on the fifth layer;
   - a seventh layer of a material like silver on the sixth layer.

In one embodiment, the stacking comprises multiple second stackings, with the layers of the different second stackings being in the same or in a different order.

In one embodiment, the structure is composed of Hastelloy or covered by an Hastelloy layer.

In one embodiment, the structure is a cylinder.

One embodiment provides a device for manufacturing a superconducting coil comprising a structure, wherein the device is adapted to implement the method according to an embodiment, and comprises:
- a rotating apparatus adapted to drive said structure into rotation; and, preferably,
- at least a heating apparatus adapted to heat the structure; wherein the device is adapted to be housed in the cold chamber, the hot chamber and/or the wet chamber.

### Brief description of drawings

The foregoing features and advantages, as well as others, will be described in detail in the following description of specific embodiments given by way of illustration and not limitation with reference to the accompanying drawings, in which:
FIG. 1 is a diagram of a method for manufacturing superconducting coils.
FIG. 2 is a perspective view of a device for manufacturing superconducting coils.
FIG. 3 is a close-up view of the structure of a superconducting coil constructed by the method for manufacturing superconducting coils of FIG. 1.
FIG. 4A and FIG. 4B are perspective views of a superconducting coil illustrating an additional optional step of a method for manufacturing superconducting coils.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

The figures are not to scale. It should be noted that the drawings refer to an embodiment of the method and device for manufacturing superconducting coils, sometimes referred simply as method or device, respectively, when no ambiguity is anticipated. Other embodiments may be possible, as someone with appropriate training may readily appreciate. The actual dimension and/or shape of each of the components of the embodiment may vary. Only important details of the embodiment are shown, however one of ordinary skill in the art can appreciate how the overall device may be constructed, without undue experimentation. Some details have been omitted from the drawings, but the inventors believe that adding these details is unnecessary for the overall appreciation of the characteristics of the invention disclosed. These omitted details include, among others, elements for holding or fixing the device or its functional components. Some characteristics of the embodiment appear exaggerated to facilitate understanding. The embodiments disclosed, and alternatives observed should not be considered as limiting the invention in any way.

In the drawings, the structure is a right circular cylinder (cylinder **202**) and the surface to be coated is an outer surface of said cylinder. In another embodiment, the surface to be coated may be an inner surface of the cylinder. Other shapes of a structure having a surface to be coated are possible. In other embodiments, the surface to be coated could be an inner or an outer surface of a non-circular and/or non-right cylinder, or any other appropriate structure.

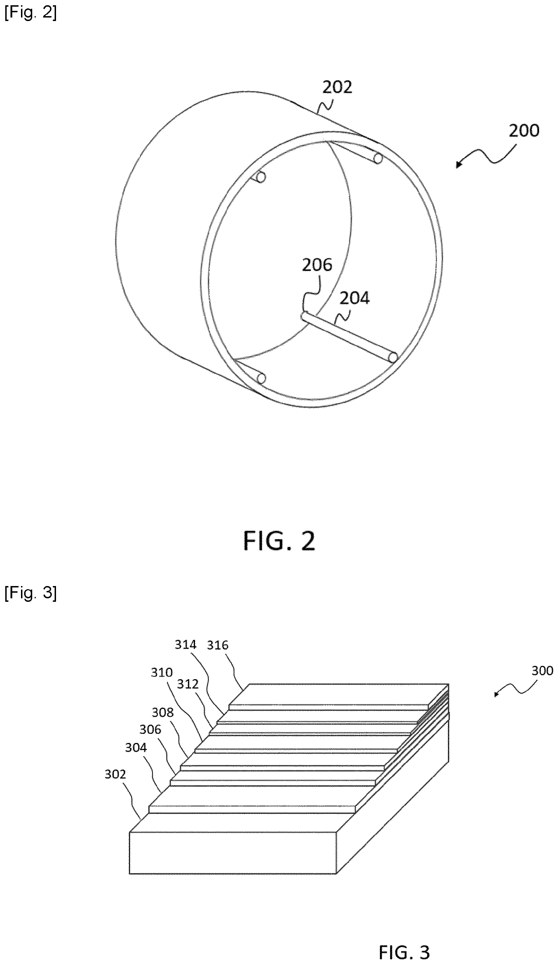

FIG. 2 is a perspective view of an embodiment of a device **200** for manufacturing superconducting coils using multistage coating. The device comprises rotating rods **204** adapted to held a flat-faced ring or hollow cylinder **202,** which is not necessarily included in the device. The cylinder **202** may be constructed of a material like Hastelloy. The rods **204** adapted to hold the cylinder **202** may also be batons, large discs, cylinders, or wheels. The rods **204** should be able to rotate, this can be done through the use of a motor or other appropriate means. Further, the cylinder **202** should be held on the rods **204** by means that would allow for the cylinder **202** to rotate with the rods **204.** At least one of the rods **204** may be connected to a heating ring or resistor **206.** The heating resistor **206** heat the rod **204** which in turn heat the cylinder **202.** The rods **204** could act as electrodes used to pass current through the cylinder **202** in order to heat it. The device from FIG. 2 may be housed inside a chamber, which is appropriate for performing operations like chemical vapor deposition CVD, metal-organic chemical vapor deposition MOCVD, or magnetron sputtering, among others. Other heating methods may be used instead of the heating resistor **206,** other embodiments may use at least an inductive or ohmic heating coil which could be included in the inside of the cylinder **202.**

When reference is made to a cylinder, this includes a flat-faced ring or a hollow cylinder.

Other examples of a device for coating uniformly a surface, which can be applied for manufacturing a superconducting coil, is given in the European patent application filed the same day than the present application by the same applicant "RENAISSANCE FUSION", entitled "UNIFORM COATING OF A SURFACE" which is hereby incorporated by reference to the maximum extent allowable by law.

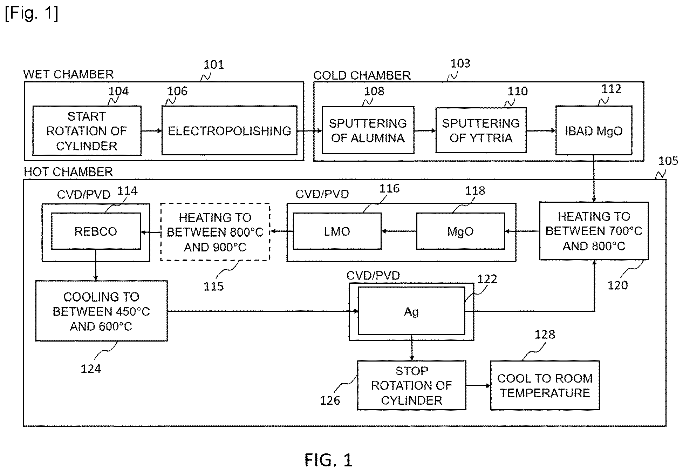

FIG. 1 is a diagram of an embodiment of a method for manufacturing superconducting coils. The method is divided into three mayor phases or stages, indicated as such because the processes in the stage occur in three different chambers: a wet chamber **101,** a cold chamber **103,** and a hot chamber **105.**

The wet chamber **101** may be filled by an electrolytic solution to perform electropolishing **106** on the surface of the cylinder **202.** Therefore, the wet chamber **101** may also include electrodes for this end.

In the cold chamber **103,** several processes may occur, based on a physical vapor deposition (PVD) technique. In the illustrated embodiment, there are three processes: two processes are based on sputtering, typically magnetron sputtering, in sputtering of alumina step **108** adapted to deposit alumina and sputtering of yttria step **110** adapted to deposit yttria, and one process is based on ion beam assisted deposition (IBAD), in IBAD MgO step **112** adapted to deposit magnesium oxide (MgO).

Other PVD techniques may be used in the cold chamber, which may depend on the material to deposit. For example:
- ion beam deposition (IBD) may be used instead of sputtering to deposit alumina and/or yttria; and/or
- sputtering, typically magnetron sputtering, or inclined substrate deposition (ISD) may be used instead of IBAD to deposit MgO.

Therefore, the cold chamber **103** preferably includes at least an ejector, like a target or a nozzle, and/or may include a source, depending on the technique used, for example for magnetron sputtering and IBAD.

When reference is made to an ejector, this may include a target or a nozzle, depending on the technique used.

The hot chamber **105** involves several processes based on a physical vapor deposition (PVD) technique and/or a chemical vapor deposition (CVD) technique. In the illustrated embodiment, at least six processes may be involved, including: the heating of the cylinder **202** to a temperature between 700°C and 800°C (first temperature) in the heating to between 700°C and 800°C step **120**; three CVD and/or PVD steps adapted to deposit materials, the MgO step **118** adapted to deposit (MgO), the LMO step **116** adapted to deposit lanthanum manganite (LMO), and the REBCO step **114** adapted to deposit rare-earth barium copper oxide (REBCO), or another appropriate superconducting material; the cooling of the cylinder **202** to between 450°C and 600°C (third temperature), for example between 500°C and 600°C, in the cooling between 450°C and 600°C step **124**; and a CVD or a PVD step adapted to deposit silver (Ag) on the surface of the cylinder **202** in the Ag step **122.**

At this stage, the cylinder may be heated again in the heating to between 700°C and 800°C step **120,** for example to repeat, at least once, the process steps in the hot chamber, or the cylinder **202** may be stopped in the stop rotation of cylinder step **126.** The method may also comprise a cool to room temperature step **128,** before, after or during the stop rotation of cylinder step **126,** where the process ends.

Currently, the cooling to between 450°C and 600°C step **124** may be envisioned to be done through convective heating, by injecting a gas or vapor that is inert at a lower temperature (fourth temperature), but other ways may also be possible.

Different CVD or PVD techniques may be used in the hot chamber, which may depend on the material to deposit. For example:
- standard CVD or MOCVD may be used to deposit MgO and/or LMO;
- MOCVD, metalorganic deposition (MOD), reaction co-evaporation (RCE), as CVD techniques, or pulsed laser deposition (PLD), as a PVD technique, may be used to deposit REBCO or another superconducting material;
- sputtering, typically DC sputtering, as a PVD technique, may be used to deposit silver;
- standard CVD or MOCVD may be used to deposit an epitaxial layer of silver.

When necessary, depending on the technique used in the REBCO step **114,** a heating to between 800°C and 900°C step **115** (second temperature), for example between 850°C and 890°C, may be needed between the LMO step **116** and the REBCO step **114,** in order to heat the cylinder **202** to a temperature adapted to the REBCO step **114.**

The hot chamber **105** preferably includes at least an ejector like a nozzle for the execution of the CVD and/or PVD processes, depending on the technique(s) used.

The temperature ranges in the cold and hot chambers are given in relation with the techniques used and the materials to deposit. The person skilled in the art will know how to adapt them for other techniques and/or other materials.

The processes in the three chambers, wet **101,** cold **103** and hot **105** chambers, may be executed in three separate chambers, meaning that the cylinder would have to be taken out of one chamber and placed in the next one, or they could all be executed in a single chamber.

### Example of operation

An example of detailed operations is now described, based on the processes illustrated in FIG. 1, and using the device of FIG. 2.

The illustrated method starts in the wet chamber **101.** In the wet chamber **101,** a cylinder **202** like the one from FIG. 2 is made to rotate in the start rotation of cylinder step **104.** The rods **204** rotate the cylinder **202.** After rotation starts, the cylinder **202** is submerged in an electrolytic solution and, alongside appropriate electrodes, an electropolishing process polishes the surface in the electropolishing step **106.** The electropolishing process may be accompanied by rinsing steps before and after the polishing and by drying afterwards. Further, the electropolishing step **106** may be repeated several times to achieve a certain level of polish. In an embodiment where the wet chamber **101** and the cold chamber **103** are separated, the cylinder **202** would now be taken into the cold chamber **103.**

In the cold chamber **103,** at least a magnetron sputtering ejector, like a target or a nozzle, deposits layers of alumina and yttria, and a target of IBAD deposits magnesium oxide MgO. The first step in the cold chamber **103** is the sputtering of alumina step **108.** A magnetron sputtering ejector injects aluminum and oxygen into the chamber, depositing alumina on the surface of the cylinder **202.** Once alumina has been deposited, the same or another magnetron sputtering ejector injects yttrium and oxygen into the chamber, depositing yttria on the cylinder surface, in the second step called sputtering of yttria step **110.** The last step in the cold chamber is the deposition of MgO through the use of ion beam assisted deposition using a target of magnesium and oxygen. This step is called the IBAD MgO step **112.** The steps in the cold chamber **103** can be executed at room temperature. Nevertheless, for the next steps in the method, the surface of the cylinder **202** must be heated. The cylinder **202** must then be transferred to a different chamber that may heat its surface or it may also be possible to heat it using the heating resistors **206.**

The first step in the hot chamber **105** is the heating of the cylinder between 700°C and 800°C in the heating to between 700°C and 800°C step **120.** At this temperature, metalorganic chemical vapor deposition MOCVD can be used to deposit MgO and LMO on top of the materials deposited on the cold chamber **103.** First, MOCVD is used to deposit MgO in the MgO step **118.** The hot chamber **105** is filled with a vaporized MgO precursor at an uniform temperature and exhibiting laminar flow around the cylinder **202,** thus depositing MgO on its surface. The same process is repeated in the LMO step **116,** this time using a lanthanum manganite LMO precursor at an uniform temperature and laminar flow. After LMO is deposited, the temperature in the hot chamber **105** may be increased further to 850°C, for example between 850°C and 890°C, in the heating to between 800°C and 900°C step **115** before the REBCO step **114.** As part of the REBCO step **114,** a superconducting material like rare-earth barium copper oxide may be filled with a vaporized REBCO precursor exhibiting laminar flow around the cylinder **202.** In an embodiment, the temperature of the REBCO precursor would be between 250°C and 280°C (fifth temperature). For each of steps MgO step **118,** LMO step **116** and REBCO step **114,** pulsed laser deposition (PLD), for example, may be used instead of MOCVD. The cylinder **202** is cooled in the next step in the cooling to between 450°C and 600°C step **124.** At this temperature it is possible to use chemical-vapor deposition or metal-organic chemical vapor deposition to deposit silver on the surface of the cylinder. Silver is deposited in the Ag step **122.**

Once the silver deposits, it is now possible to heat the cylinder again and repeat the previous steps of the method. It is possible to repeat the following six or seven steps in order: the heating to between 700°C and 800°C step **120,** the MOCVD MgO step **118,** the LMO step **116,** in some cases, the heating to between 850°C and 890°C step **115,** the REBCO step **114,** the cooling to between 450°C and 600°C step **124,** and the (MO)CVD addition of Ag step **122.** These steps may be repeated any number of times, with a total of between 4 and 80 repetitions, for example between 20 and 40 repetitions, being considered appropriate for at least this embodiment.

At any step of the method, but preferably after the (MO)CVD addition of Ag step **122,** the cylinder **202** may be made to stop by stopping the rods **204,** this is the stop rotation of cylinder step **126.** Once the cylinder **202** has been stopped, it may be left to cool to room temperature, in the cool to room temperature step **128.** Afterwards, the cylinder **202** may be removed from the chamber and it may then be cut or used as per the needs of the application.

### Structure of a superconducting coil

An example of superconducting coil **300** constructed by following the diagram from FIG. 1 would be composed of chemically or otherwise bonded layers as shown in FIG. 3. The very first layer is the Hastelloy layer **302,** which may be polished in the electropolishing step **106** in the wet chamber **101.** Once the cylinder **202** is in the cold chamber **103,** the other layers are added. On top of the Hastelloy layer **302,** a layer of alumina is sputtered in the sputtering of alumina step **108,** this is the alumina layer **304.** On top of the alumina layer **304,** yttria is sputtered as part of the sputtering of yttria step **110,** this is the yttria layer **306.** On top of the yttria layer **306,** a layer of MgO is deposited, this is done in the IBAD MgO step **112** and results in the first MgO layer **308.** The cylinder **202** is then introduced into the hot chamber **105** and the last layers are added. The next layer to be added is a second MgO layer **310.** A second MgO layer **310** is deposited through the use of MOCVD on top of the first MgO layer **308.** The MOCVD process is also used to deposit a layer of lanthanum manganite LMO on top of the second MgO layer **310,** this is the LMO layer **312.** MOCVD is used once again to deposit a layer of REBCO on top of the LMO layer **312,** this is the REBCO layer **314.** CVD or MOCVD is preferably used to deposit a layer of silver Ag on top of the REBCO layer **314,** this is the silver layer **316.** Forming the silver layer using (MO)CVD has an advantage, compared to a sputtering technique for example, of forming a layer with a suitable crystal, which can be beneficial if a new sequence of layers is formed on the silver layer.

All the layers formed in the cold chamber may be called "first stacking of layers" or "first stacking", and all the layers formed in the hot chamber may be called "second stacking of layers" or "second stacking".

The alumina, yttria, MgO, LMO layers may be called "buffer layers". The buffer layers may form an appropriate template for the formation of the superconducting layer.

The final four layers, second MgO layer **310,** LMO layer **312,** REBCO layer **314** and silver layer **316** may be deposited repeatedly in the same or different order. They may be deposited repeatedly on top of the layers deposited during the process in the cold chamber **103** in order to create a layer stack or wafer of between 4 and 80, for example between 20 and 40 layers.

Other appropriate materials, and number of layers, may be used in place of the ones described here.

For example, instead of the MgO layer in the cold chamber, an yttrium stabilized zirconia (YSZ) layer may be formed, using a PVD technique like sputtering, ISD, IBD or IBAD, and instead of the MgO layer in the hot chamber, an epitaxial YSZ layer may be formed, using for example CVD, MOCVD, or a PVD technique like IBAD.

As another example, instead of the described sequence of layers, the following sequence may be formed on the Hastelloy layer **302** preferably in the following order:
- a first CeO₂ layer and a YSZ layer in the cold chamber, using a PVD technique like IBD and/or sputtering;
- a second CeO₂ layer, optionally a LMO layer, a REBCO layer, and a silver layer in the hot chamber, using a PVD technique and/or CVD technique like one of the techniques already cited, depending on the material to deposit.

Other embodiments may replace REBCO with other rare-earth materials that exhibit high-temperature superconductivity, like YBCO.

In another embodiment, the last silver layer, that is, the silver layer of the last sequence of layers in case of repetition of layers **310, 312, 314, 316,** may be replaced by a copper layer. Indeed, the silver layer is particularly adapted as a starting layer for a repetition of layers, but is of less interest in the last sequence on which no repetition is made, and a copper layer is cheaper, faster to grow using electroplating for example and harder than silver.

### Additional embodiments

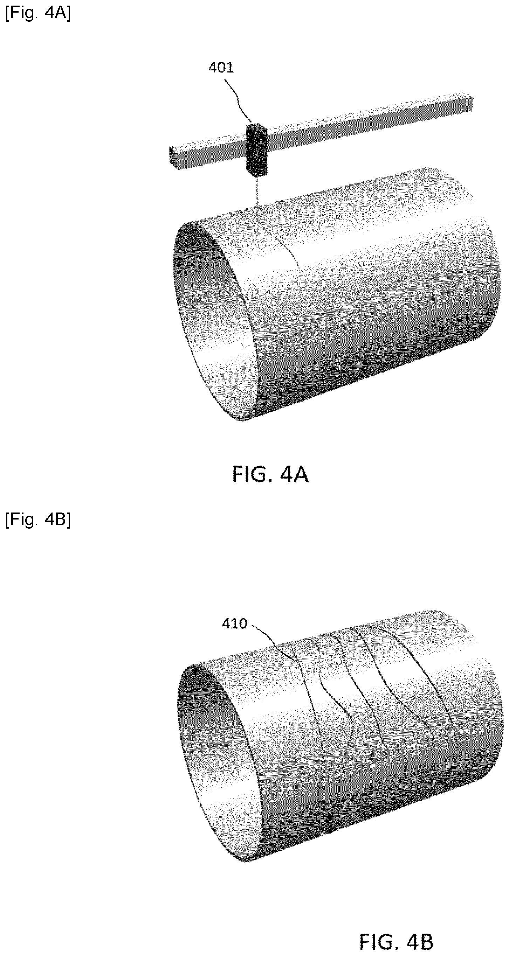

After the last silver layer is formed, an additional step of removing material at least from the silver layer, the superconductive layer and possibly the buffering layers may be provided, in order to create a pattern that form grooves **410,** as illustrated in figure 4B. The pattern shape may depend on the application. In order to remove the material, a technique like laser patterning **401** may be used, as illustrated in figure 4A. Other techniques, like a mechanical technique or photolithography may be used. The grooves may be filled with a metal, for example silver.

The cylinder of the superconducting coil may be machined to have a particular shape, and the superconducting coil may be assembled to another superconducting coil, of a similar or different shape, like several modular coils, to form an assembly. For example, several superconducting coils may be assembled to form a stellarator.

Example embodiments of the invention are summarized here. Other embodiments can also be understood from the entirety of the specification as well as the claims filed herein.

Example 1. A method for manufacturing a superconducting coil, the method comprising steps of:
- providing a structure (202);
- rotating the structure;
- forming a first stacking of layers on the rotating structure in a cold chamber (103); and
- forming a second stacking of layers on the first stacking of the rotating structure in a hot chamber (105) at a temperature higher than the temperature in the cold chamber.

Example 2. The method according to example 1, further comprising, after the rotating step and before forming the first stacking, a step of electropolishing the structure in a wet chamber (101), for example using an electrolytic solution and electrodes.

Example 3. The method according to example 2, wherein the wet chamber (101), the cold chamber (103) and the hot chamber (105) are a single chamber.

Example 4. The method according to example 2, wherein the wet chamber (101), the cold chamber (103) and the hot chamber (105) are separate chambers.

Example 5. The method according to any one of examples 1 to 4, wherein:
- the step of forming the first stacking in the cold chamber (103) comprises using at least an ejector adapted to a physical vapor deposition step, like a nozzle and/or a target; and/or
- the step of forming the second stacking in the hot chamber (105) comprises using at least an ejector adapted to a physical vapor deposition step and/or to a chemical vapor deposition step, like a nozzle and/or a target.

Example 6. The method according to any one of examples 1 to 5, wherein the temperature in the cold chamber (103) is the room temperature and/or the temperature in the hot chamber is higher than 500°C.

Example 7. The method according to any one of examples 1 to 6, wherein forming the first stacking comprises at least a physical vapor deposition step, like sputtering, for example magnetron sputtering, inclined substrate deposition, ion beam deposition and/or ion beam assisted deposition.

Example 8. The method according to any one of examples 1 to 7, wherein forming the first stacking comprises:
- depositing, for example using sputtering or ion beam deposition, a first layer (304) of a material like alumina on the structure (202);
- depositing, for example using sputtering or ion beam deposition, a second layer (306) of a material like yttria on the first layer (304); and
- depositing, for example using sputtering or ion beam assisted deposition, a third layer (308) of a material like magnesium oxide or yttrium stabilized zirconia on the second layer (306).

Example 9. The method according to any one of examples 1 to 8, wherein forming the second stacking comprises at least a physical vapor deposition step, for example sputtering or pulsed laser deposition, and/or a chemical vapor deposition step, for example a metal organic chemical vapor deposition step.

Example 10. The method according to any one of examples 1 to 9, wherein forming the second stacking comprises depositing at least a layer (314) of a superconductive material, for example rare-earth barium copper oxide or yttrium barium copper oxide, using metal-organic chemical vapor deposition, for example using a vaporized precursor at a uniform temperature and laminar flow, or using pulse pulsed laser deposition.

Example 11. The method according to example 10, wherein forming the second stacking comprises a step of depositing a layer (316) of a low-resistivity material like silver on the superconductive material layer (314).

Example 12. The method according to any one of examples 1 to 11, wherein forming the second stacking comprises:
- heating the structure (202) to a first temperature, for example between 700°C and 800°C;
- depositing, for example using metal-organic chemical vapor deposition or pulse pulsed laser deposition, a fourth layer (310) of a material like magnesium oxide or yttrium stabilized zirconia on the first stacking;
- depositing, for example using metal-organic chemical vapor deposition or pulse pulsed laser deposition, a fifth layer (312) of a material like lanthanum manganite on the fourth layer;
- depositing, for example using chemical vapor deposition, metal-organic chemical vapor deposition or pulse pulsed laser deposition, a sixth layer (314) of a superconductive material, for example rare-earth barium copper oxide or yttrium barium copper oxide, on the fifth layer;
- cooling the structure to a third temperature lower than the first temperature, for example between 450°C and 600°C; and
- depositing, preferably using chemical vapor deposition or metal-organic chemical vapor deposition, a seventh layer (316) of a low-resistivity material like silver on the sixth layer.

Example 13. The method according to example 12, wherein the cooling step comprises injecting an inert gas or vapor at a fourth temperature lower than the third temperature.

Example 14. The method according to example 12 or 13, wherein the step of depositing the sixth layer (314) comprises filling in the hot chamber a vaporized superconductive material precursor at a fifth temperature, for example between 250°C and 280°C.

Example 15. The method according to any of examples 12 to 14, further comprising heating the structure (202) to a second temperature higher than the first temperature, for example between 800°C and 900°C, between depositing the fifth layer and depositing the sixth layer.

Example 16. The method according to any of examples 1 to 15, further comprising repeating the steps of forming the second stacking, in the same or in different order, in order to form at least multiple second stackings on the first stacking, preferably several times, for example between 4 and 80 times.

Example 17. The method according to any of examples 1 to 16, further comprising, preferably after the step of forming the second stacking or the multiple second stackings:
- stopping the rotation of the structure; and/or
- cooling the structure to the room temperature.

Example 18. A superconducting coil (300) obtained by the method of any one of examples 1 to 17, the superconducting coil comprising:
- a structure (202);
- a first stacking of layers on the structure;
- a second stacking of layers on the first stacking.

Example 19. The superconducting coil (300) of example 18, wherein:
- the first stacking of layers on the structure comprises:
   - a first layer (304) of a material like alumina on the structure;
   - a second layer (306) of a material like yttria on the first layer;
   - a third layer (308) of a material like magnesium oxide on the second layer;
- at least a second stacking of layers on the first stacking comprising:
   - a fourth layer (310) of a material like magnesium oxide or yttrium stabilized zirconia on the third layer;
   - a firth layer (312) of a material like lanthanum manganite on the fourth layer;
   - a sixth layer (314) of a superconductive material like rare-earth barium copper oxide or yttrium barium copper oxide on the fifth layer;
   - a seventh layer (316) of a material like silver on the sixth layer.

Example 20. The superconducting coil of example 18 or 19, comprising multiple second stackings, with the layers of the different second stackings being in the same or in a different order.

Example 21. The method of any of examples 1 to 17, or the superconducting coil of any of examples 18 to 20, wherein the structure (202) is composed of Hastelloy or covered by an Hastelloy layer (302), and/or the structure is a cylinder.

Example 22. A device (200) for manufacturing a superconducting coil comprising a structure (202), wherein the device is adapted to implement the method of any of examples 1 to 17, and comprises:
- a rotating apparatus adapted to drive said structure into rotation; and, preferably,
- at least a heating apparatus (206) adapted to heat the structure;
   wherein the device is adapted to be housed in the cold chamber (103), the hot chamber (105) and/or the wet chamber (101).

Example 23. The device according to example 22, wherein the rotation apparatus is adapted to held the structure.

Example 24. The device according to example 22 or 23, wherein the rotating apparatus comprises:
- at least one rolling piece (204), preferably a plurality of rolling pieces, adapted to be coupled to another surface of the apparatus (202) different from the surface to be coated in such a way that the rotation of the at least one rolling piece causes the rotation of the structure; and
- at least a driving unit, like a motor, adapted to be coupled to the at least one rolling piece in order to drive it into rotation.

Example 25. The device according to example 24, wherein the at least one rolling piece (204) is a baton, a rod, a disc, a cylinder, or a wheel.

Example 26. The device according to any of examples 22 to 25, wherein the heating apparatus comprises a heating resistor (206) connected to at least one rolling piece (204), an inductive coil or an ohmic heating coil.

Various embodiments and variants have been described. Those skilled in the art will understand that certain features of these embodiments can be combined and other variants will readily occur to those skilled in the art.

Finally, the practical implementation of the embodiments and variants described herein is within the capabilities of those skilled in the art based on the functional description provided hereinabove.

### List of acronyms:

- HTS: High-Temperature Superconductors
- Ag: Silver
- LMO: Lanthanum manganite
- MgO: Magnesium oxide
- REBCO: Rare-earth barium copper oxide
- YBCO: Yttrium barium copper oxide
- YSZ: Yttrium Stabilized Zirconia
- CeO₂: Cerium oxide
- PVD: Physical Vapor Deposition
- IBAD: Ion Beam Assisted Deposition
- IBD: Ion Beam Deposition
- PLD: Pulsed Laser Deposition
- ISD: Inclined Substrate Deposition
- CVD: Chemical Vapor Deposition
- MOCVD: Metal-organic Chemical Vapor Deposition
- MOD: Metalorganic Deposition
- RCE: Reaction Co-Evaporation

## Claims

1. A method for manufacturing a superconducting coil, the method comprising steps of:
- providing a structure (202);
- rotating the structure;
- forming a first stacking of layers on the rotating structure in a cold chamber (103); and
- forming a second stacking of layers on the first stacking of the rotating structure in a hot chamber (105) at a temperature higher than the temperature in the cold chamber.

2. The method according to claim 1, further comprising, after the rotating step and before forming the first stacking, a step of electropolishing the structure in a wet chamber (101), for example using an electrolytic solution and electrodes.

3. The method according to claim 2, wherein the wet chamber (101), the cold chamber (103) and the hot chamber (105) are a single chamber.

4. The method according to claim 2, wherein the wet chamber (101), the cold chamber (103) and the hot chamber (105) are separate chambers.

5. The method according to any one of claims 1 to 4, wherein:
- the step of forming the first stacking in the cold chamber (103) comprises using at least an ejector adapted to a physical vapor deposition step, like a nozzle and/or a target; and/or
- the step of forming the second stacking in the hot chamber (105) comprises using at least an ejector adapted to a physical vapor deposition step and/or to a chemical vapor deposition step, like a nozzle and/or a target.

6. The method according to any one of claims 1 to 5, wherein the temperature in the cold chamber (103) is the room temperature and/or the temperature in the hot chamber is higher than 500°C.

7. The method according to any one of claims 1 to 6, wherein forming the first stacking comprises at least a physical vapor deposition step, like sputtering, for example magnetron sputtering, inclined substrate deposition, ion beam deposition and/or ion beam assisted deposition.

8. The method according to any one of claims 1 to 7, wherein forming the first stacking comprises:
- depositing, for example using sputtering or ion beam deposition, a first layer (304) of a material like alumina on the structure (202);
- depositing, for example using sputtering or ion beam deposition, a second layer (306) of a material like yttria on the first layer (304); and
- depositing, for example using sputtering or ion beam assisted deposition, a third layer (308) of a material like magnesium oxide or yttrium stabilized zirconia on the second layer (306).

9. The method according to any one of claims 1 to 8, wherein forming the second stacking comprises at least a physical vapor deposition step, for example sputtering or pulsed laser deposition, and/or a chemical vapor deposition step, for example a metal organic chemical vapor deposition step.

10. The method according to any one of claims 1 to 9, wherein forming the second stacking comprises depositing at least a layer (314) of a superconductive material, for example rare-earth barium copper oxide or yttrium barium copper oxide, using metal-organic chemical vapor deposition, for example using a vaporized precursor at a uniform temperature and laminar flow, or using pulsed laser deposition.

11. The method according to claim 10, wherein forming the second stacking comprises a step of depositing a layer (316) of a low-resistivity material like silver on the superconductive material layer (314).

12. The method according to any one of claims 1 to 11, wherein forming the second stacking comprises:
- heating the structure (202) to a first temperature, for example between 700°C and 800°C;
- depositing, for example using metal-organic chemical vapor deposition or pulsed laser deposition, a fourth layer (310) of a material like magnesium oxide or yttrium stabilized zirconia on the first stacking;
- depositing, for example using metal-organic chemical vapor deposition or pulsed laser deposition, a fifth layer (312) of a material like lanthanum manganite on the fourth layer;
- depositing, for example using chemical vapor deposition, metal-organic chemical vapor deposition or pulsed laser deposition, a sixth layer (314) of a superconductive material, for example rare-earth barium copper oxide or yttrium barium copper oxide, on the fifth layer;
- cooling the structure to a third temperature lower than the first temperature, for example between 450°C and 600°C; and
- depositing, preferably using chemical vapor deposition or metal-organic chemical vapor deposition, a seventh layer (316) of a low-resistivity material like silver on the sixth layer.

13. The method according to claim 12, wherein the cooling step comprises injecting an inert gas or vapor at a fourth temperature lower than the third temperature.

14. The method according to claim 12 or 13, wherein the step of depositing the sixth layer (314) comprises filling in the hot chamber a vaporized superconductive material precursor at a fifth temperature, for example between 250°C and 280°C.

15. The method according to any of claims 12 to 14, further comprising heating the structure (202) to a second temperature higher than the first temperature, for example between 800°C and 900°C, between depositing the fifth layer and depositing the sixth layer.

16. The method according to any of claims 1 to 15, further comprising repeating the steps of forming the second stacking, in the same or in different order, in order to form at least multiple second stackings on the first stacking, preferably several times, for example between 4 and 80 times.

17. A superconducting coil (300) obtained by the method of any one of claims 1 to 16, the superconducting coil comprising:
- a structure (202);
- a first stacking of layers on the structure;
- a second stacking of layers on the first stacking.

18. The superconducting coil (300) of claim 17, wherein
- the first stacking of layers on the structure comprises:
- a first layer (304) of a material like alumina on the structure;
- a second layer (306) of a material like yttria on the first layer;
- a third layer (308) of a material like magnesium oxide on the second layer;
- at least a second stacking of layers on the first stacking comprising:
- a fourth layer (310) of a material like magnesium oxide or yttrium stabilized zirconia on the third layer;
- a firth layer (312) of a material like lanthanum manganite on the fourth layer;
- a sixth layer (314) of a superconductive material like rare-earth barium copper oxide or yttrium barium copper oxide on the fifth layer;
- a seventh layer (316) of a material like silver on the sixth layer.

19. The superconducting coil of claim 17 or 18, comprising multiple second stackings, with the layers of the different second stackings being in the same or in a different order.

20. A device (200) for manufacturing a superconducting coil comprising a structure (202), wherein the device is adapted to implement the method of any of claims 1 to 16, and comprises:
- a rotating apparatus adapted to drive said structure into rotation; and, preferably,
- at least a heating apparatus (206) adapted to heat the structure;
wherein the device is adapted to be housed in the cold chamber (103), the hot chamber (105) and/or the wet chamber (101) .
